# EUROPÄISCHE PATENTSCHRIFT

(11) **EP 0 478 002 B1**
(45) Veröffentlichungstag und Bekanntmachung des Hinweises auf die Patenterteilung: **03.04.1996**
(21) Anmeldenummer: 91119416.5
(22) Anmeldetag: 21.12.1988
(51) Int. Cl.: H03M 1/30, G06K 11/06, H03J 9/06

(54) **Drahtloses Fernsteuersystem elektronischer Geräte**
Wireless remote control system of electronic sets
Télécommande sans fil pour appareils électroniques

(30) Priorität: 30.04.1988 EP 88106983
(43) Veröffentlichungstag der Anmeldung: 01.04.1992
(62) Teilanmeldung aus: 88121384.7
(73) Patentinhaber: Deutsche ITT Industries GmbH, D-79108 Freiburg (DE)
(72) Erfinder: Heberle, Klaus, Dipl.-Ing. (FH), W-7801 Reute (DE)

(56) Entgegenhaltungen:
- EP-A- 0 206 246
- EP-A- 0 209 411
- US-A- 2 948 890

## Beschreibung

Übliche Fernsteuergeber von drahtlosen Fernsteuersystemen ' elektronischer Geräte, insbesondere solcher der Unterhaltungselektronik, erzeugen in Abhängigkeit von vom Benutzer zu betätigenden Tasten Steuersignale für das bzw. die zu steuernden Geräte. Dabei dient als Übertragungsmedium ein entsprechend moduliertes Ultraschall- bzw. Infrarot-Signal.

Im Hinblick auf die Vielzahl der heute möglichen und damit auch erforderlichen Steuerbefehle erscheint es nicht mehr tragbar, die Anzahl der Tasten des Fernsteuergebers weiter zu erhöhen, sondern sie ist gerade drastisch zu verringern, ohne dabei jedoch die Steuermöglichkeiten zu reduzieren.

Aus EP-A-0 209 411 ist ein Steuersystem für ein elektronisches Gerät bekannt, das einem Piloten mittels einer Kopfbewegung ermöglicht, ein Steuersignal auszulösen. Dabei werden dem Piloten mittels eines Bildschirms eine Vielzahl von Steuerbefehlen zur Auswahl angeboten. Jeder Steuerbefehl ist einem auf dem Bildschirm dargestellten kleinen Feld zugeordnet und der Pilot wählt daraus den gewünschten Steuerbefehl aus. Dieses Verfahren ist bei der Bedienung von Computern unter dem Namen "Menü-Steuerung" bekannt. Statt der üblichen Menü-Auswahl beim Computer mittels einer manuell bewegten "Maus" erfolgt in der Anordnung nach EP-A-0 209 411 die Menü-Auswahl durch die Kopfbewegung des Piloten. Hierzu wird die relative Position zwischen dem Helm des Piloten und einem festen Bezugspunkt mittels eines elektrooptischen Systems bestimmt. Dieses besteht im wesentlichen auf der Fernbedienungsempfängerseite aus einer optischen Strahlungsquelle, die räumlich fest angeordnet ist, und auf der Fernbedienungsgeberseite aus einem optischen Vierquadranten-Strahlungsdetektor, der fest mit dem Pilotenhelm verbunden und auf die Strahlungsquelle ausgerichtet ist. Mit der Kopfbewegung ändert sich die Lage der abgebildeten Strahlungsquelle auf dem mitbewegten Strahlungsdetektor - der Leuchtfleck bewirkt dabei eine andere Lichtverteilung auf dem Vierquadranten-Strahlungsdetektor. Seine elektrischen Ausgangssignale werden über Draht einer teilweise analog, teilweise digital arbeitenden Rechenschaltung zugeführt, die mit der Ablenkeinheit und Strahlsteuerung des Bildschirmes gekoppelt ist und dort dasjenige Feld hervorhebt, das der jeweiligen Helmausrichtung zugeordnet ist.

Aus GB-A 1 203 597 ist ein Gerät bekannt, das eine x-y-Koordinanteneinstellung über jeweils eine Linienrasterplatte in x- und y-Richtung steuert, wobei die jeweilige Anzahl der durchlaufenen Linien optisch abgetastet und elektronisch gezählt wird.

Aus EP-A 0 206 246 ist eine optisch gesteuerte "Maus" zur Computersteuerung bekannt, die über diagonal liegende photoempfindliche Sensoren das Gitterraster eines "Tabletts" abtastet und die elektrischen Signale einer Auswertungsschaltung zuführt. Zur Steuerung wird die Maus manuell auf dem Tablett in beliebiger Richtung bewegt.

Aus US-A 3 996 463 ist ein Gerät bekannt, das mittels des Fraunhoferschen Diffraktionseffekt die relative Position zwischen einem Lichtstrahl und einem optischen Gitter auswertet. Dies ermöglicht eine genaue Positionsbestimmung bei sehr kleinen Relativbewegungen.

Aus US-A-2 948 890 ist eine weitere Anordnung bekannt, die an einem Gerät eine relative Positionsbestimmung in einer Richtung mittels elektrooptischer Mittel ermöglicht. Die Anordnung verwendet eine Maske mit streifenförmigen Öffnungen und einen dahinterliegenden Reflektor mit streifenförmigen Reflexionszonen. Die Relativbewegung zwischen der Streifenmaske und dem dahinterliegenden Reflektor erzeugt ein Hell-Dunkel-Signal, dessen Wechsel zur Positionsbestimmung elektronisch ausgewertet wird. Dies erfolgt beispielsweise durch einfache Zählung der Helligkeitsimpulse. Der jeweilige Richtungssinn der Bewegung wird durch eine parallele zweite Streifenmaske ermittelt, die gegenüber der ersten etwas versetzt ist und entsprechend ein zeitlich versetzes Hell-Dunkel-Signal erzeugt.

In der europäischen Stammanmeldung EP-A 0 340 343 und der weiteren europäischen Teilanmeldung EP-A-0 479 333 - beide mit gleichem Zeitrang wie die vorliegende europäische Teilanmeldung - werden weitere drahtlose Fernsteuersysteme für elektronische Geräte beschrieben, die die Relativbewegung zwischen einem Fernbedienungsgeber und einem Fernbedienungsempfänger mittels elektrooptischer Mittel in elektronische Signale umwandeln, aus denen sich auf einfache Weise die Relativbewegung oder die jeweilige Position ermitteln lassen.

Es ist Aufgabe der in den Ansprüchen gekennzeichneten Erfindung, das in EP-A 0 209 411 beschriebene elektrooptische System an ein drahtloses Fernsteuersystem für elektronische Geräte, insbesondere der Unterhaltungselektronik, anzupassen. Somit können aus der Relativbewegung zwischen Fernsteuergeber und einer ortsfesten Strahlungsquelle, die z.B. am zu steuernden Gerät angebracht ist, Signale abgeleitet werden, die eine Information über die Bewegungsrichtung und die Bewegungsgeschwindigkeit des Fernsteuergebers enthalten.

Mittels dieser Signale und des in heute üblichen Fernsteuergebern bzw. elektronischen Geräten vorhandenen und entsprechend programmierten Mikroprozessors können die Fernsteuersignale erzeugt werden.

Die Erfindung wird nun anhand der Figuren der Zeichnung näher erläutert:
Fig. 1 zeigt stark schematisiert das der Erfindung zugrundeliegende Prinzip,
Fig. 2a zeigt stark schematisiert die bei der Erfindung verwendeten Lichtsammler und Fig. 2b deren Ausgangssignale,
Fig. 3 zeigt schematisch in perspektivischer Darstellung einen der Lichtsammler nach Fig. 2a sowie die räumliche Zuordnung der Zylinderlinse nach Fig. 1,
Fig. 4 zeigt eine einfache Schaltung zur Ableitung von Richtungssignalen aus den beiden Ausgangssignalen der Anordnung nach Fig. 2a und
Fig. 5a und 5b zeigen Kurvenverläufe der Eingangs- und Ausgangssignale der Fig. 4.

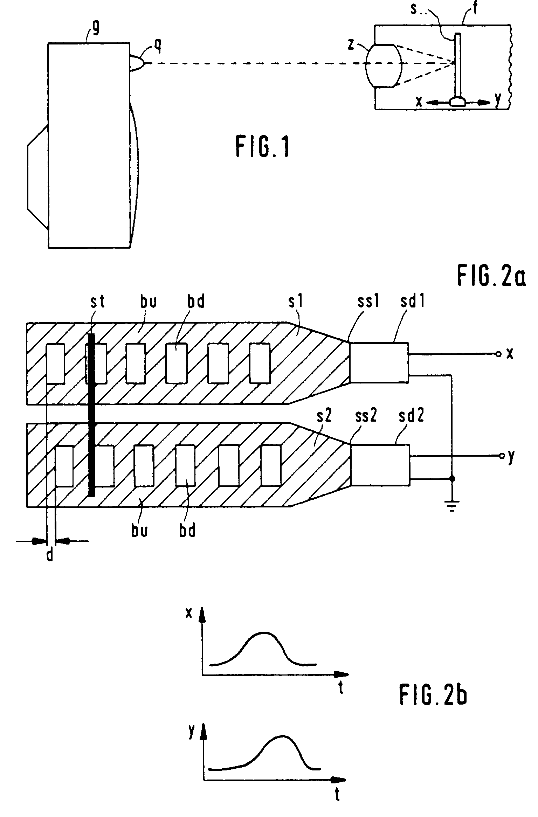

Gemäß der Erfindung befindet sich entsprechend der stark schematisierten Fig. 1 am als Fernsehgerät dargestellten elektronischen Gerät g die Strahlungsquelle q, die vorzugsweise als eine Infrarotstrahlungsquelle und als punktförmig zu betrachten ist.

Vom Fernsteuergeber f ist derjenige Teil gezeigt, der die elektrooptische Eingangsstufe enthält, da dessen übrige Teile von üblicher Art sind (es ist also selbstverständlich zusätzlich zu der ortsfesten Strahlungsquelle q eine von den Fernsteuersignalen gespeiste Strahlungsquelle vorhanden, der im elektronischen Gerät g mindestens ein entsprechender Strahlungsempfänger zugeordnet ist). Die von der Strahlungsquelle q emittierte Strahlung wird mittels der Zylinderlinse z auf die Lichtsammler s... projiziert, deren von der Strahlungs bestrichene Sammlerfläche vorzugsweise in der Brennebene der Zylinderlinse z angeordnet ist, so daß die praktisch punktförmige Strahlungsquelle q als Strich st, vgl. Fig. 2a, darauf abgebildet wird.

In Fig. 2a ist die konstruktive Ausbildung der beiden Lichtsammler s1, s2 sowie deren gegenseitige räumliche Zuordnung schematisch gezeigt. Sie sind bezüglich ihrer Längsachse nebeneinander angeordnet, und ein regelmäßiges Muster von abwechselnd strahlungsdurchlässigen bzw. strahlungsundurchlässigen Bereichen bd, bu ist auf der jeweiligen bestrahlten Sammlerfläche angebracht. Dabei ist das Muster des Lichtsammlers s1 gegenüber dem des Lichtsammlers s2 seitlich um den Abstand d versetzt, der vorzugsweise gleich der Hälfte der Breite der lichtdurchlässigen Bereiche bd ist. Am jeweiligen Strahlungssammelort ss1, ss2 der beiden Lichtsammler s1, s2 ist der jeweilige Strahlungsdetektor sd1, sd2 angeordnet, an dessen jeweiligem Ausgang das Signal x bzw. y entsteht. In Fig. 2a ist veranschaulicht, daß jeweils ein Anschluß der beiden Strahlungsdetektoren mit dem Schaltungsnullpunkt (Masse) verbunden werden kann.

In Fig. 2b ist schematisch gezeigt, welchen zeitlichen Verlauf die Ausgangssignale x, y haben, wenn der Strich st bei Bewegung des Fernsteuergebers f über die strahlungsdurchlässigen bzw. -undurchlässigen Bereiche bd, bu wandert. Wichtig dabei ist, daß die in der jeweiligen Kurve auftretenden Maxima zeitlich gegeneinander versetzt sind.

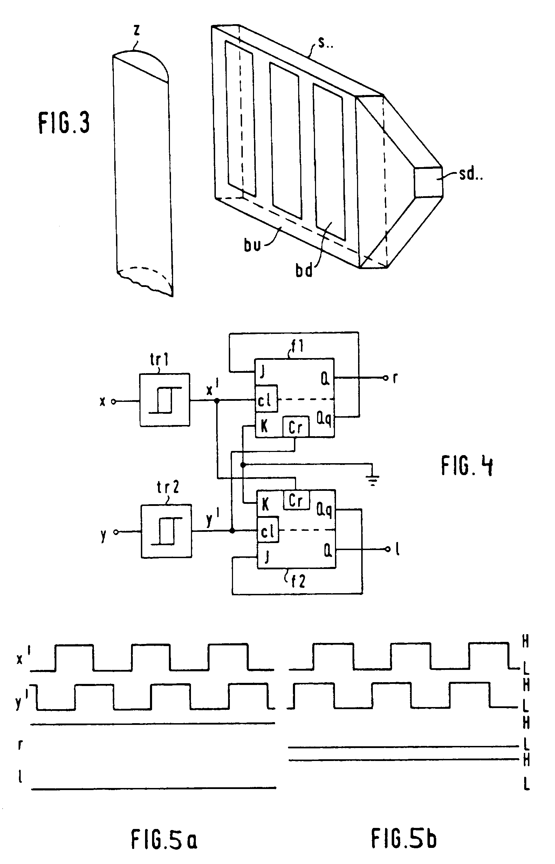

Die Fig. 3 zeigt in perspektivischer Darstellung schematisch die Ausbildung der Lichtsammler s... sowie die räumliche Zuordnung der Zylinderlinse z. Die Lichtsammler s... bestehen aus einem Material, vorzugsweise einem entsprechenden Kunststoff, der die durch die strahlungsdurchlässigen Bereiche bd seitlich eintretende Strahlung durch Totalreflexion an den anderen Begrenzungsflächen zum Strahlungssammelort sd... weiterleitet. Dies erspart eine Vielzahl von einzelnen Strahlungsdetektoren.

Die Fig. 4 zeigt eine einfache Schaltung aus den beiden Schmitt-Triggern tr1, tr2 und den beiden JK-Flipflops f1, f2, mit denen aus den Ausgangssignalen x, y der elektrooptischen Eingangsstufe nach Fig. 1 die elektrischen Signale r, 1 erzeugt werden können, die unter anderem die Information über die Bewegungsrichtung des Fernsteuergebers f enthalten.

Die in Fig. 5a und 5b dargestellten rechteckförmigen Ausgangssignale x', y' entsprechen somit idealisiert dem zeitlichen Ablauf des über die jeweiligen Strahlungsdetektoren sd1, sd2 hinweggeführten Hell-Dunkelrasters. Im einzelnen ist mit dem jeweiligen Ausgangssignal der Schmitt-Trigger tr1, tr2 der jeweilige Takteingang c1 der beiden JK-Flipflops f1, f2 gespeist. Ferner ist der Clear-Eingang Cr des JK-Flipflops f2 mit dem Ausgang des Schmitt-Triggers tr1 und der Clear-Eingang Cr des JK-Flipflops f1 mit dem Ausgang des Schmitt-Triggers tr2 verbunden. Die beiden K-Eingänge der JK-Flipflops f1, f2 liegen am Schaltungsnullpunkt, während in jedem Flipflop der J-Eingang mit dem Qq-Ausgang verbunden ist. Am Q-Ausgang des Flipflops f1 entsteht das Signal r, das eine Rechtsbewegung anzeigt, und am Q-Ausgang des Flipflops f2 das Signal 1, das eine Linksbewegung anzeigt. Die Schmitt-Trigger tr1, tr2 bilden aus den Ausgangssignalen x, y, die eher sin- oder sin-förmig sind, vgl. Fig. 2b, die in Fig. 5a und 5b gezeigten Rechtecksignale x', y'.

Die in Fig. 4 gezeigte einfache Auswerteschaltung erzeugt lediglich die Information, ob eine Rechts- oder eine Linksbewegung vorliegt. Zur Auswertung der zugehörigen Geschwindigkeit kann die momentane Frequenz der Rechtecksignale x', y' ausgewertet werden, vgl. Fig. 5a und 5b. Aus der von einem bestimmten Zeitpunkt an akkumulierten Taktanzahl von x' oder y' kann die Bewegungsweite bestimmt werden.

Die Fig. 5a zeigt den zeitlichen Verlauf der Signale x', y', r, l bei einer Rechtsbewegung, bei der die x'-Signale gegenüber den y'-Signalen voreilen, während die Fig. 5b den Fall für eine Linksbewegung zeigt, in der die x'-Signale den y'-Signalen nacheilen. In Fig. 5a hat das r-Signal den H-Pegel und das l-Signal den L-Pegel. In Fig. 5b hat das l-Signal den H-Pegel und das r-Signal den L-Pegel (der H-Pegel ist der positivere der beiden vom jeweiligen Q-Ausgang einnehmbaren Pegel H, L).

Die in Fig. 5a und 5b gezeigten vier Signale enthalten wie angegeben sowohl die Information über die Bewegungsrichtung des Fernsteuergebers f als auch Informationen darüber, wie weit und wie schnell er bewegt wird. Somit ist es für den Fachmann ohne weiteres möglich, den eingangs erwähnten, im Fernsteuergeber oder elektronischen Gerät vorhandenen Mikroprozessor mit diesen Signalen anzusteuern und daraus entsprechende Fernsteuersignale für das elektronische Gerät g zu bilden. Mittels der Information über die Bewegungsweite des Fernsteuergebers f läßt sich ein analoges bzw. kontinuierliches Steuersignal, wie z.B. für die Lautstärke oder für die Helligkeit oder den Kontrast, erzeugen. Es sind jedoch auch sogenannte Menü-Steuerungen möglich, wie sie von Computern und der bekannten sogenannten Maus her bekannt und üblich sind. Der Fernsteuergeber kann somit nach der Erfindung als "elektronische Maus" ausgebildet werden.

Es kann zweckmäßig sein, in den Fernsteuergeber ein zweites elektrooptisches System vom gleichen Aufbau wie das vorhandene elektrooptische System nach den Figuren 1 bis 3 einzubauen, das dann gegenüber dem ersten um 90^{o} gedreht angeordnet ist, dies ermöglicht dann zusätzlich die vertikale Bewegungserkennung.

Wird die Strahlung der Strahlungsquelle q moduliert, so ist auch eine bi-direktionale Datenverbindung mit dem Fernsteuergeber möglich.

## Patentansprüche

1. Drahtloses Fernsteuersystem elektronischer Geräte
- mit einem Fernsteuergeber (f) und einem im elektronischen Gerät (g) angeordneten Fernsteuerempfänger,
- mit einer im elektronischen Gerät (g) angeordneten Strahlungsquelle (q),
- mit mindestens zwei im Fernsteuergeber (f) angeordneten Strahlungsdetektoren (sd1, sd2) sowie
- mit den Strahlungsdetektoren (sd1, sd2) zugeordneten Mitteln zur Erzeugung von elektrischen Signalen (x, y) aus der Relativbewegung zwischen Fernsteuergeber (f) und Fernsteuerempfänger bzw. elektronischem Gerät (g),
dadurch gekennzeichnet, daß
die elektrooptische Eingangsstufe des Fernsteuergebers (f) ein elektrooptisches System enthält, das im Strahlungsverlauf hintereinander angeordnet eine Zylinderlinse (z) und zwei nebeneinanderliegende Lichtsammler (s1, s2) enthält, auf deren jeweiliger von der aus der Zylinderlinse austretenden Strahlung überstrichenen Sammlerfläche ein regelmäßiges Muster von abwechselnd strahlungsdurchlässigen bzw. -undurchlässigen Bereichen (bd, bu) und an deren jeweiligem Strahlungssammelort (ss1, ss2) jeweils einer der Strahlungsdetektoren (sd1, sd2) angeordnet ist, wobei das eine Muster gegen das andere Muster versetzt ist.

2. Drahtloses Fernsteuersystem nach Anspruch 1, dadurch gekennzeichnet, daß die elektrooptische Eingangsstufe ein zweites elektrooptisches System vom gleichem Aufbau wie das (erste) elektrooptische System enthält, wobei das zweite System gegenüber dem ersten in einer zu dessen Ebene parallelen Ebene um 90^{o} gedreht angeordnet ist.

3. Drahtloses Fernsteuersystem nach Anspruch 1 oder 2, dadurch gekennzeichnet, daß die elektronischen Geräte (g) Geräte der Unterhaltungselektronik sind.

4. Drahtloses Fernsteuersystem nach einem der Ansprüche 1 bis 3, dadurch gekennzeichnet, daß mittels der Relativbewegung des Fernsteuergebers (f) gegenüber der Strahlungsquelle (q) analoge bzw. kontinuierliche Steuersignale auf den Fernsteuerempfänger übertragen werden.

5. Drahtloses Fernsteuersystem nach einem der Ansprüche 1 bis 3, dadurch gekennzeichnet, daß mittels der Relativbewegung des Fernsteuergebers (f) gegenüber der Strahlungsquelle (q) Menü-Steuersignale übertragen werden.

6. Drahtloses Fernsteuersystem nach einem der Ansprüche 1 bis 5, dadurch gekennzeichnet, daß die Ausgangssignale (x, y) der Strahlungsdetektoren (sd1, sd2) über logische Verknüpfungen Richtungssignale (r, l) erzeugen.

## Claims

1. A wireless remote-control system for electronic apparatus, said remote-control system comprising
- a remote-control transmitter (f) and a remote-control receiver which is contained in the electronic apparatus (g),
- a radiation source (q) contained in the electronic apparatus (g),
- at least two radiation detectors (sd1, sd2) contained in the remote-control transmitter (f), and
- means associated with the radiation detectors (sd1, sd2) for generating electric signals (x, y) from a movement of the remote-control transmitter (f) and the remote-control receiver or the electronic apparatus (g) relative to each other,
**characterized in that**
the electrooptical input stage of the remote-control transmitter (f) comprises an electrooptical system in which a cylindrical lens (z) and two light collectors (s1, s2) lying side by side are arranged one behind the other in the radiation path, the respective collector surfaces of the light collectors, which are swept by the radiation emerging from the cylindrical lens, being provided with a regular pattern of alternately transparent and opaque areas (bd, bu), and a respective one of the radiation detectors (sd1, sd2) being located at the respective radiation collection points (ss1, ss2) of the light collectors (s1, s2), with one pattern displaced relative to the other.

2. A wireless remote-control system as claimed in claim 1, characterized in that the electrooptical input stage comprises a second electrooptical system of the same design as the (first) electrooptical system, with the second system rotated by 90° with respect to the first system in a plane parallel to the plane of the first system.

3. A wireless remote-control system as claimed in claim 1 or 2, characterized in that the electronic apparatus (g) is entertainment-electronics apparatus.

4. A wireless remote-control system as claimed in any one of claims 1 to 3, characterized in that by means of the movement of the remote-control transmitter (f) relative to the radiation source (q), analog or continuous control signals are transmitted to the remote-control receiver.

5. A wireless remote-control system as claimed in any one of claims 1 to 3, characterized in that by means of the movement of the remote-control transmitter (f) relative to the radiation source (q), menu-control signals are transmitted.

6. A wireless remote-control system as claimed in any one of claims 1 to 5, characterized in that the output signals (x, y) from the radiation detectors (sd1, sd2) produce direction signals (r, 1) via logic elements.

## Revendications

1. Système de télécommande sans fil d'appareils électroniques, comportant
- un générateur de télécommande (f) et un récepteur de télécommande disposé dans l'appareil électronique (g),
- une source de rayonnement (q) disposée dans l'appareil électronique (g),
- au moins deux détecteurs de rayonnement (sd1, sd2) disposés dans le générateur de télécommande (f), et
- des moyens associés aux détecteurs de rayonnement (sd1, sd2) pour produire des signaux électriques (x,y) à partir du déplacement relatif entre le générateur de télécommande (f) et le récepteur de télécommande ou l'appareil électronique (g),
caractérisé en ce que
l'étage d'entrée électro-optique du générateur de télécommande (f) contient un système électro-optique, qui contient, rangés les uns derrière les autres dans la direction de rayonnement, une lentille cylindrique (z) et deux collecteurs de lumière (s1, s2) disposés côte-à-côte, un modèle régulier de zones (bd, bu) alternativement transparentes et opaques au rayonnement étant disposé sur la surface respective du collecteur de lumière, qui est balayé par le rayonnement sortant de la lentille cylindrique, tandis que respectivement l'un des détecteurs de rayonnement (sd1, sd2) est disposé à l'emplacement respectif de collecte du rayonnement (ss1, ss2) de ces collecteurs de lumière, un modèle étant décalé par rapport à l'autre modèle.

2. Système de télécommande sans fil selon la revendication 1, caractérisé en ce que l'étage d'entrée électro-optique contient un second système électro-optique possédant le même agencement que le (premier) système électro-optique, le second système étant disposé en étant pivoté de 90° par rapport au premier système, dans un plan parallèle au plan de ce système.

3. Système de télécommande sans fil selon la revendication 1 ou 2, caractérisé en ce que les appareils électroniques (g) sont des appareils de l'électronique du spectacle.

4. Système de télécommande sans fil selon l'une des revendications 1 à 3, caractérisé en ce que des signaux analogiques ou continus sont transmis au récepteur de télécommande au moyen du déplacement relatif du générateur de télécommande (f) par rapport à la source de rayonnement (q).

5. Système de télécommande sans fil selon l'une des revendications 1 à 3, caractérisé en ce que des signaux de commande de menu sont transmis au moyen du déplacement relatif du générateur de télécommande (f) par rapport à la source de rayonnement (q).

6. Système de télécommande sans fil selon l'une des revendications 1 à 5, caractérisé en ce que les signaux de sortie (x,y) des détecteurs de rayonnement (sd1, sd2) produisent, au moyen de combinaisons logiques, des signaux de direction (r,l).
